# EUROPÄISCHE PATENTSCHRIFT

(11) **EP 2 893 567 B1**
(45) Veröffentlichungstag und Bekanntmachung des Hinweises auf die Patenterteilung: **01.07.2020**
(21) Anmeldenummer: 13762064.7
(22) Anmeldetag: 05.09.2013
(51) Int. Cl.: H01L 31/167, H01L 25/16, H01L 31/0216, G01N 21/31, H01L 31/0232, G02B 5/20, G01N 21/47, G02B 1/04, H01L 25/075, G02B 5/28

(54) **MESSMODUL ZUR REMISSIONS-PHOTOMETRISCHEN ANALYSE**
MEASURING MODULE FOR REMISSION PHOTOMETRIC ANALYSIS
MODULE DE MESURE POUR L'ANALYSE PHOTOMÉTRIQUE PAR RÉMISSION

(30) Priorität: 06.09.2012 DE 102012018015
(43) Veröffentlichungstag der Anmeldung: 15.07.2015
(73) Patentinhaber: JENOPTIK Optical Systems GmbH, 07745 Jena (DE); Roche Diabetes Care GmbH, 68305 Mannheim (DE); F. Hoffmann-La Roche AG, 4070 Basel (CH)
(72) Erfinder: BUCHWALD, Jan, 07745 Jena (DE); GAUMITZ, Susanne, 07570 Weida (DE); KALVERAM, Stefan, 68519 Viernheim (DE); TRICK, Sebastian, 68239 Mannheim (DE)
(74) Vertreter: Waldauf, Alexander
(86) Internationale Anmeldenummer: PCT/EP2013/002667
(87) Internationale Veröffentlichungsnummer: WO 2014/037112

(56) Entgegenhaltungen:
- EP-A1- 1 314 972
- DE-A1- 19 835 094
- DE-A1-102010 018 052
- DE-A1-102010 048 088
- US-A- 5 260 584

## Beschreibung

Die vorliegende Erfindung bezieht sich auf ein Messmodul gemäß dem Oberbegriff von Patentanspruch 1.

Die DE 198 35 094 A1 offenbart eine Vorrichtung zur Spektralmessung von Objekten, bei denen das Objekt mit Strahlung eines breiten Spektrums beleuchtet wird und vom Objekt reflektierte oder transmittierte Strahlung auf eine Empfängeranordnung derart geleitet wird, dass die gesamte Empfängeranordnung Strahlung aus dem gleichen Raumgebiet empfängt, wobei die Strahlung spektral aufgeteilt wird.

Derartige Messmodule gemäß dem Oberbegriff sind aus dem Stand der Technik hinlänglich bekannt und werden beispielsweise dazu verwendet, um biologische Proben wie Blut oder Urin oder Umweltproben nach dem Messprinzip der Remission, also des an der Probe diffus reflektierten Lichts, zu analysieren. Hierzu ist es notwendig, dass eine von der Messstrahlung in der Probe angeregte Nebenstrahlung gefiltert wird, so dass die Messung nicht verfälscht wird. Ebenso kann als Messprinzip direkte Reflexion verwendet werden. Gemäß dem Stand der Technik sind diese Filter jedoch als separate Bauteile, beispielsweise aus Glas, ausgebildet. Die Bearbeitung derartiger Filter aus Glas ist teuer und somit kostenintensiv.

Es ist daher Aufgabe der vorliegenden Erfindung, ein verbessertes Messmodul zur Verfügung zu stellen, das insbesondere kompakter aufgebaut ist und somit kostengünstiger hergestellt werden kann. Diese Aufgabe wird durch ein Messmodul gemäß dem Patentanspruch 1 gelöst. Vorteilhafte Weiterbildungen werden durch die abhängigen Ansprüche näher definiert. Erfindungsgemäß wird unter einer Nebenstrahlung die Strahlung verstanden, die das eigentliche Messsignal negativ beeinflussen kann, wie zum Beispiel Eigenfluoreszenz der Probe, Nebenmaximas der Lichtquelle oder Sendeeinrichtung, Umgebungslicht usw.. Durch die Kombination der zweiten Fokussiereinrichtung mit dem Filter zu einer Baueinheit kann auf zusätzliche Bauteile verzichtet werden. Zudem erweist sich eine derartige Anordnung als kompakt und leicht zu handhaben.

Als Messmodul wird erfindungsgemäß eine Messeinheit verstanden, die die von einer Sendeeinrichtung an einer zu untersuchenden Probe reflektierte Strahlung 12b mittels einer Empfangseinrichtung empfängt und detektiert. Als Sendekanal und Empfangskanal wird erfindungsgemäß jeder Verlaufsweg verstanden, der eine Messstrahlung von einer Sendeeinrichtung zu einer oder einer Mehrzahl an Proben führt und die reflektierte Messstrahlung zu einer Empfangseinrichtung weiterführt.

Bevorzugt ist der Filter als eine Filterschicht ausgebildet, wobei die Schicht mehrere Schichten umfassen muss und somit als ein Schichtsystem ausgebildet ist. Beispielsweise kann das Schichtsystem die Materialien Siliziumoxid, Tantalpentoxid und/ oder Titanoxid in abwechselnder Reihenfolge umfassen. Die gesamte Filterschicht weist bevorzugt eine Dicke von größer als 0,5 µm und kleiner als 4,5 µm aufweist. Die einzelnen Schichten des Schichtsystems weisen bevorzugt eine Dicke von größer 10 nm und kleiner 300 nm auf. Der Filter oder die Filterschicht kann somit als ein Interferenzfilter verstanden werden.

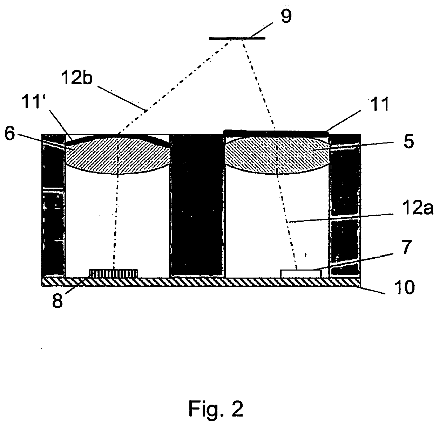

Erfindungsgemäß soll unter einem Filter jede optische Einheit verstanden werden, die die einfallende Nebenstrahlung einer Probe selektiert. Auch hier offenbart ist ein Verfahren zum Herstellen eines erfindungsgemäßen Messmoduls mit folgenden Merkmalen: Herstellen einer ersten und zweiten Fokussiereinrichtung mittels Kunststoff; Umspritzen der ersten und zweiten Fokussiereinrichtung derart, dass ein Gehäuse ausgebildet wird; Aufdampfen eines Filters auf die zweite Fokussiereinrichtung. In einer weiteren Ausgestaltung der Erfindung ist der Filter auf mindestens einem der beiden Fokussiereinrichtungen 5; 6 aufgedampft (Fig. 2). Auf beiden Fokussiereinrichtungen kann dann vorteilhaft sein, wenn zum Beispiel eine Nebenstrahlung an der Beleuchtungseinheit bzw. Sendeeinheit auftritt. Fig. 2 zeigt eine solche Prinzipdarstellung mit mindestens zwei Filtern 11; 11'. Der Filter kann auch so ausgestaltet sein, dass er sich direkt der Oberfläche der Fokussiereinrichtung anpasst, siehe 11'.
Es ist sowohl möglich, dass in einem ersten Verfahrensschritt die erste und zweite Fokussiereinrichtung gefertigt werden und anschließend die beiden Fokussiereinrichtungen mittels Kunststoff umspritzt werden, so dass ein Gehäuse ausgebildet wird. Alternativ ist es auch möglich die Verfahrensschritte zeitlich zu vertauschen und somit zuerst das Kunststoffgehäuse zu spritzen. Derartige Verfahrensabläufe sind dem Fachmann auch als Zwei-Komponenten-Spritzguss-Verfahren bekannt.

Der Schritt des Aufdampfens des Filters erfolgt bevorzugt durch einen PVD Bedampfungsprozess mittels ionenstrahlgestützter Plasmaquelle. Ein derartiges Verfahren eignet sich sehr gut für die Abscheidung von dünnen Schichten, wobei die Schichten zudem einen hohen Reinheitsgrad aufweisen.

Es versteht sich, dass die eben beschriebenen Ausführungsformen in Alleinstellung oder in Kombination untereinander dargestellt werden können. Weitere wichtige Merkmale der vorliegenden Erfindung ergeben sich aus der nachfolgenden detaillierten Beschreibung in Verbindung mit den Ansprüchen und Figuren. Nachfolgend wird ein bevorzugtes Ausführungsbeispiel eines erfindungsgemäßen Messmoduls beschrieben und mittels der Figur näher erläutert.

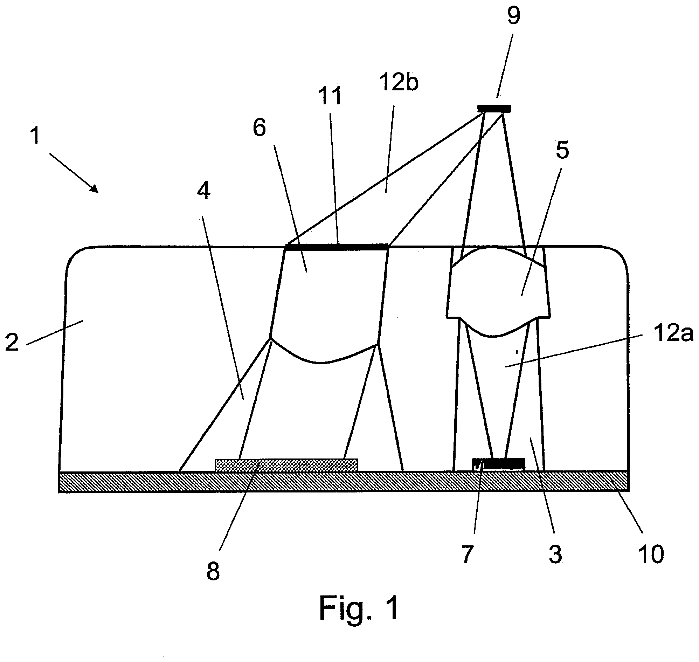

Fig. 1 zeigt schematisch den Aufbau eines erfindungsgemäßen Messmoduls 1. Ein derartiges Messmodul ist beispielsweise geeignet, die an biologischen oder Umweltproben 9 reflektierte Strahlung zu messen und zu analysieren.
Fig. 2 zeigt eine Prinzipskizze eines optischen Messmoduls gemäß der vorliegenden Erfindung in alternativer Ausführung.

Das Messmodul umfasst zumindest eine Sendeeinrichtung 7. Die Sendeeinrichtung ist als eine oder eine Mehrzahl von Leuchtdioden ausgebildet. Beispielsweise strahlt die eine oder die Mehrzahl von Leuchtdioden eine quasi-monochromatischen Messstrahlung 12a im Bereich von 300 nm bis 1300 nm ab. In einer besonderen Ausführungsweise hat die Messstrahlung eine Wellenlänge von 365 nm. Der Sendeeinrichtung nachgeordnet ist eine erste Fokussiereinrichtung 5 in einem Sendekanal 3, die als eine fokussierende Strahloptik ausgebildet ist und die Messstrahlung auf die zu untersuchende Probe 9 fokussiert. Die Probe 9 wird beispielsweise in einem separaten nicht dargestellten Probenhalter gehalten, wobei der Probenhalter ausgebildet sein kann, um mehrere Proben aufnehmen zu können. Die fokussierende Strahloptik ist erfindungsgemäß als eine Sammellinse aus Kunststoff ausgebildet, wobei die Herstellung bevorzugt im Spritzgussverfahren erfolgt.

Die von der Probe 9 reflektierte Strahlung (sog. Remission) wird mittels einer Empfangseinrichtung 8 detektiert, um die entsprechenden Messwerte zu gewinnen, anhand deren auf die Zusammensetzung der Probe rückgeschlossen werden kann. Als Empfangseinrichtung 8 können beispielsweise eine oder eine Mehrzahl an Photodioden verwendet werden. Bevorzugt werden die Mehrzahl an Photodioden zu Arrays zusammengefasst und parallel oder in Reihe verschaltet, um die Empfindlichkeit der Empfangseinrichtung zu steigern und ein hinreichend großes Messareal zur Verfügung zu stellen.

Um die reflektierte Messstrahlung auf die Empfangseinrichtung 8 zu fokussieren, ist dieser eine zweite Fokussiereinrichtung 6 in einem Empfangskanal 4 vorgelagert. Die zweite Fokussiereinrichtung 6 ist ebenfalls als fokussierende Strahlungsoptik aus Kunststoff ausgebildet.

Erfindungsgemäß ist nun vorgesehen, lediglich die von der Probe reflektierte Strahlung auszuwerten. Eine von der Messstrahlung angeregte Nebenstrahlung soll der Messung nicht zugänglich sein. Um diese Nebenstrahlung von der Messung auszublenden, die beispielsweise eine Wellenlängenverschiebung von der Sendeeinrichtung von 20 nm bis 200 nm aufweisen kann, in einer besonderen Ausführung bei 460 nm, ist erfindungsgemäß ein Filter 11 vorgesehen, der auf die zweite Fokussiereinrichtung aufgedampft wird. Beispielsweise kann dies durch einen PVD-Bedampfungsprozess (Physical Vapour Deposition) erfolgen.

Die gesamten Komponenten des Moduls sind in einem gemeinsamen Gehäuse 2 untergebracht. Das Gehäuse 2 kann beispielsweise durch einen ersten Spritzgießprozess hergestellt werden, während die optischen Komponenten wie die erste und zweite Fokussiereinrichtung in einem zweiten nachfolgenden Spritzgießprozess hergestellt werden können. Ein derartiges Verfahren ist dem Fachmann auch unter dem Begriff "Zwei-Komponenten-SpritzgussVerfahren" bekannt. Hierbei ist es sowohl möglich, dass zuerst das Gehäuse gespritzt wird oder umgekehrt zuerst die optischen Komponenten. Abgeschlossen wird das Gehäuse mit einer Grundplatte 10, die ebenfalls aus Kunststoff ausgebildet sein kann.

Zum Betreiben der Empfangseinrichtung 8 ist ferner eine nicht dargestellte Steuervorrichtung vorgesehen. Diese Steuervorrichtung wirkt mit der Sendeeinrichtung 7 zusammen und stellt Schaltsignale für diese bereit. Ferner umfasst die Steuervorrichtung einen Verstärker für die von der Empfangseinrichtung gemessene Strahlung.

## Patentansprüche

1. Messmodul (1) zur remissions-photometrischen Analyse von einer (9) oder einer Mehrzahl Proben mit folgenden Merkmalen:
- einer Sendeeinrichtung (7) mit einem Sendekanal (3) zum Aussenden einer Messstrahlung (12a) zum Ort der Probe (9);
- einer ersten Fokussiereinrichtung (5) zum Fokussieren der Messstrahlung auf die Probe;
- einer Empfangseinrichtung (8) mit einem Empfangskanal (4) zum Empfangen der durch die Probe reflektierten Strahlung (12b);
- einer zweiten Fokussiereinrichtung (6) zum Fokussieren der durch die Probe reflektierten Messstrahlung auf die Empfangseinrichtung (8), wobei die zweite Fokussiereinrichtung (6) einen Filter (11) umfasst, **dadurch kennzeichnet, dass**
die zweite Fokussiereinrichtung (6) aus Kunstoff besteht und
der Filter (11), der auf die zweite Fokussiereinrichtung aufgedampft ist, dazu ausgebildet ist, eine durch die Messstrahlung angeregte Nebenstrahlung, wie zum Beispiel Eigenfluoreszenz der Probe, Nebenmaximas der Lichtquelle oder Sendeeinrichtung, Umgebungslicht oder dergleichen der Probe zu filtern.

2. Messmodul (1) nach Anspruch 1, **dadurch gekennzeichnet, dass** der Filter (11) als eine Filterschicht ausgebildet ist.

3. Messmodul (1) nach Anspruch 2, **dadurch gekennzeichnet, dass** die Filterschicht als ein mehrschichtiges System ausgebildet ist und bevorzugt eine Dicke größer als 0,5 µm und kleiner als 4,5 µm aufweist.

4. Messmodul (1) nach Anspruch 3, **dadurch gekennzeichnet, dass** die einzelnen Schichten des mehrschichtigen Systems eine Dicke von größer 10 nm und kleiner 300 nm aufweisen und folgende Materialien in abwechselnder Reihenfolge aufweisen: Siliziumoxid, Tantalpentoxid und/ oder Titanoxid.

5. Messmodul nach einem der vorhergehenden Ansprüche, **dadurch gekennzeichnet, dass** die Sendeeinrichtung (7), die Empfangseinrichtung (8), die erste und zweite Fokussiereinrichtung (5,6) in einem gemeinsamen Gehäuse (2), insbesondere aus Kunststoff, angeordnet sind.

6. Messmodul (1) nach einem der vorhergehenden Ansprüche, **dadurch gekennzeichnet, dass** die Sendeeinrichtung (7) als eine oder eine Mehrzahl an Leuchtdioden ausgebildet ist und die Empfangseinrichtung (8) als eine oder eine Mehrzahl an Photodioden ausgebildet ist.

## Claims

1. Measuring module (1) for a diffuse reflectance photometric analysis of one (9) or more samples, comprising the following features:
- a transmitter device (7) with a transmission channel (3) for emitting measuring radiation (12a) toward the location of the sample (9);
- a first focusing device (5) for focusing the measuring radiation on the sample;
- a receiver device (8) with a reception channel (4) for receiving the radiation (12b) reflected by the sample;
- a second focusing device (6) for focusing the measuring radiation reflected by the sample onto the receiver device (8),
wherein the second focusing device (6) comprises a filter (11),
**characterized in that**
the second focusing device (6) consists of plastic and the filter (11), which is vapour deposited onto the second focusing device, is embodied to filter secondary radiation, such as for example autofluorescence of the sample, secondary maxima of the light source or transmitter device, ambient light or the like from the sample, excited by the measuring radiation.

2. Measuring module (1) according to Claim 1, **characterized in that** the filter (11) is embodied as a filter layer.

3. Measuring module (1) according to Claim 2, **characterized in that** the filter layer is embodied as a multi-layered system and preferably has a thickness greater than 0.5 µm and less than 4.5 µm.

4. Measuring module (1) according to Claim 3, **characterized in that** the individual layers of the multi-layered system have a thickness of greater than 10 nm and less than 300 nm and include the following materials in an alternating sequence: silicon oxide, tantalum pentoxide and/or titanium oxide.

5. Measuring module according to any one of the preceding claims, **characterized in that** the transmitter device (7), the receiver device (8) and the first and second focusing device (5, 6) are disposed in a common housing (2), in particular a housing made of plastic.

6. Measuring module (1) according to any one of the preceding claims, **characterized in that** the transmitter device (7) is embodied as one or more light-emitting diodes and the receiver device (8) is embodied as one or more photodiodes.

## Revendications

1. Module de mesure (1) pour l'analyse photométrique par rémission d'un (9) ou d'une pluralité d'échantillons, ayant les caractéristiques suivantes :
- un dispositif d'émission (7) comprenant un canal d'émission (3) servant à émettre un rayonnement de mesure (12a) vers l'endroit de l'échantillon (9) ;
- un premier dispositif de focalisation (5) destiné à focaliser le rayonnement de mesure sur l'échantillon ;
- un dispositif de réception (8) comprenant un canal de réception (4) servant à recevoir le rayonnement (12b) réfléchi par l'échantillon ;
- un deuxième dispositif de focalisation (6) destiné à focaliser le rayonnement de mesure réfléchi par l'échantillon sur le dispositif de réception (8),
le deuxième dispositif de focalisation (6) comportant un filtre (11),
**caractérisé en ce que**
le deuxième dispositif de focalisation (6) se compose de matière plastique et
le filtre (11), qui est appliqué par évaporation sur le deuxième dispositif de focalisation, est configuré pour filtrer un rayonnement secondaire excité par le rayonnement de mesure, par exemple la fluorescence propre de l'échantillon, les lobes secondaires de la source de lumière ou du dispositif d'émission, la lumière ambiante ou similaire.

2. Module de mesure (1) selon la revendication 1, **caractérisé en ce que** le filtre (11) est réalisé sous la forme d'une couche filtrante.

3. Module de mesure (1) selon la revendication 2, **caractérisé en ce que** la couche filtrante est réalisée sous la forme d'un système multicouche et présente de préférence une épaisseur supérieure à 0,5 µm et inférieure à 4,5 µm.

4. Module de mesure (1) selon la revendication 3, **caractérisé en ce que** les couches individuelles du système multicouche présentant une épaisseur supérieure à 10 nm et inférieure à 300 nm et possèdent les matériaux suivants en séquence alternée : oxyde de silicium, pentoxyde de tantale et/ou oxyde de titane.

5. Module de mesure selon l'une des revendications précédentes, **caractérisé en ce que** le dispositif d'émission (7), le dispositif de réception (8), le premier et le deuxième dispositif de focalisation (5, 6) sont disposés dans un boîtier (2) commun, notamment en matière plastique.

6. Module de mesure (1) selon l'une des revendications précédentes, **caractérisé en ce que** le dispositif d'émission (7) est réalisé sous la forme d'une ou d'une pluralité de diodes électroluminescentes et le dispositif de réception (8) est réalisé sous la forme d'une ou d'une pluralité de photodiodes.
